# EUROPEAN PATENT SPECIFICATION

(11) **EP 2 179 895 B1**
(45) Date of publication and mention of the grant of the patent: **28.09.2011**
(21) Application number: 08018684.4
(22) Date of filing: 24.10.2008
(51) Int. Cl.: B60R 16/023, H05K 7/20

(54) **Vehicle electronic system with fluid cooling**
Elektronisches Fahrzeugsystem mit Flüssigkeitskühlung
Système électronique de véhicule avec refroidissement de fluide

(43) Date of publication of application: 28.04.2010
(73) Proprietor: Harman Becker Automotive Systems GmbH, 76307 Karlsbad (DE)
(72) Inventor: Noshadi, Valod, 76275 Ettlingen (DE); Woinkoff, Juri, 76319 Karlsruhe (DE)
(74) Representative: Bertsch, Florian Oliver

(56) References cited:
- EP-A- 0 968 885
- DE-C- 19 645 635
- GB-A- 2 183 304

## Description

This invention relates to a vehicle electronic system using a cooling fluid for removing the heat generated by the heat source or sources within the electronic system.

### Related Art

Automotive electronic devices are nowadays cooled in general through thermal conduction to their frames and surrounding walls, radiation heat exchange with the surrounding and air convection. In many cases where the natural convection does not suffice to stay within the temperature limits given for automotive applications, fan systems are used that are driving the surrounding air through the electronic devices in order to enhance the cooling by forced convection.

The trend towards superior graphical performance and the increasing demand for speech and sound processing lead to the implementation of faster and specialized processors as well as high memory capacities. Another aspect is the higher packing density resulting from the fact that more and more electronic devices have to be incorporated in a limited space. The operating temperature limits impose restrictions to the hardware engineers in selection of proper processing units. Many powerful processors are specified only for consumer electronics and those specified for automotive applications are either expensive or have the lowest possible upper temperature limits. The car manufacturers need to mount different electronic devices in the limited space available at the dashboard and request the devices to function in surrounding temperatures up to 85°C. Considering the limitations of air cooling, the full function of the electronic devices can sometimes be only guaranteed up to 65°C surrounding temperatures with short temperature peaks up to 70°C.

GB 2 183 304 A discloses an electronically controlled fuel injection pump according to the preamble of Claim 1, which is cooled by fuel oil passing through a cooling passage formed between each heat transfer plate.

DE 196 45 635 C1 discloses a cooling body for an electronic motor, the heat generating units of the electric motor being connected to the lower and upper side of the cooling body.

EP 0 968 885 A2 discloses a cooling unit for an electronic control unit comprising a chill plate with a cover in which a channel is formed that represents a flow conduit for the fuel.

### Summary

Accordingly, a need exists to provide an effective cooling for a vehicle electronic system.

This need is met by the features of the independent claims. Preferred embodiments of the invention are described in the dependent claims.

According to the invention, a vehicle electronic system is provided comprising a housing in which at least one heat source is provided. The electronic system furthermore comprises a cooling fluid channel for guiding a cooling fluid through the housing. Furthermore, a heat sink plate is present to which said at least one heat source is connected. The heat sink plate furthermore comprises recessed areas partly building the cooling fluid channel. By providing a heat sink plate with the recessed areas which partly build the cooling fluid channel through which cooling fluid such as water or any other synthetic liquid is flowing, an effective cooling with low space requirements can be obtained. As a cooling liquid or fluid can more effectively transport the generated heat, a cooling fan can be eliminated.

Furthermore, a cover plate may be provided building the cooling channel together with the heat sink plate. In this embodiment with two plates a small area between the two plates built by the recessed areas can be obtained which build the cooling fluid channel. In this embodiment, the recessed areas of the heat sink plate build three side walls of the cooling fluid channel whereas the cover plate builds the other remaining fourth side wall of the cooling fluid channel. The cover plate building the other side wall may be planar in the region of the cooling fluid channel. However, it is also possible that the cover plate comprises recessed areas in order to increase the volume provided for the cooling fluid flowing through the cooling fluid channel. With the two plates, the heat sink plate and the cover plate the cooling fluid channel can be generated in an easy and cost effective way. The cooling fluid can flow in the recessed parts of the heat sink plate. As the large heat sources are directly coupled to the heat sink plate, the heat can be transferred in a very effective way. As a consequence, the operating temperatures of the heat sources such as processing units are lowered what will result in a longer lifetime of the heat source. Due to the fact that no cooling fan needs to be provided, the noise of the fan can be avoided and there will be no dust accumulating in the housing of the electronic system through dust particles contained in the cooling air. Furthermore, humidity condensation problems can be avoided.

An additional advantage can be seen in the fact that the heat generating units or heat sources can be thermally decoupled from their immediate surrounding. This gives the car manufacturer more freedom to choose the mounting position of the electronic system in the vehicle.

In order to facilitate the controlling of the fluid flow, the cooling fluid inlet and the cooling fluid outlet may be provided on one side surface of the housing. By providing the cooling fluid inlet and outlet on the same side surface, the fluid path outside the electronic system can be minimized.

According to the invention the, vehicle electronic system is incorporated into a support structure of a vehicle cabin such as the dashboard or the main console. When a cooling fluid channel as described above is used, the side surfaces of the housing not facing the vehicle cabin can be substantially free of air supply openings. These air supply openings are necessary when cooling air is used for removing the generated heat. As the air inlet and outlet openings are not necessary anymore, this will result in an improved electromagnetic compatibility (EMC). With the closed housing without air inlet and outlet openings, other electronic devices provided in the neighbourhood will have less interfering effects.

According to the invention the most effective cooling is obtained when the heat sources generating the biggest amount of heat are provided on the heat sink plate on the recessed areas by directly connecting them to the recessed areas. Accordingly, the recessed areas or the form of the cooling fluid channel can be selected depending on the geometrical arrangement of the heat sources within the housing. The heat sources can either be directly connected to the heat sink plate or a heat conducting pad can be used through which the heat source is attached to the heat sink plate.

According to one embodiment of the invention, the cover plate building one side surface of the cooling fluid channel builds the bottom surface of the housing. In this embodiment, the heat sink plate and the cover plate are both provided in the lower part of the housing, the heat sources being provided on the heat sink plate that is super-positioned on the cover plate. However, it should be understood that the two plates building the cooling fluid channel need not to be provided on the lower or upper end of the housing. The two plates may also be provided in the middle of the housing viewed in the direction of the height of the housing. In this embodiment heat sources may additionally be connected to the cover plate in case the cover plate is also able to transfer the generated heat.

In one embodiment, the cover plate and the heat sink plate are metallic plates which might be connected to each other by brazing. In the case the cover plate is not a metallic plate, but a plastic cover plate, the cover plate may be adhered to the heat sink plate using other connection techniques such as cementing.

Preferably, the heat sink plate and the cover plate are substantially planar surfaces extending over the complete surface area of the housing. Preferably, these two plates cover the whole surface area of the housing. Due to the large surface area of these plates, enough space is provided to locate the different heat generating units or heat sources on the heat sink plate.

The different embodiments described above may also be combined in various ways.

### Brief Description of the Drawings

In the following, the invention will be described in further detail with reference to the accompanying drawings.
Fig. 1 shows a perspective rear view of the vehicle electronic system comprising a cooling fluid channel for cooling fluid,
Fig. 2 shows a perspective rear view of a system of Fig. 1 with the front and the top side of the housing being removed,
Fig. 3 shows a perspective bottom view of the housing with a cover plate building the bottom plate being removed,
Fig. 4 shows a perspective view of the housing of Fig. 3 with the cover plate on the bottom being provided,
Fig. 5 shows a perspective front view with the top side being removed,
Fig. 6 shows a perspective bottom view of the housing with the cover plate and the heat dissipating plate being removed showing the main board, and
Fig. 7 shows a partial sectional view through the housing.

### Detailed Description of Preferred Embodiments

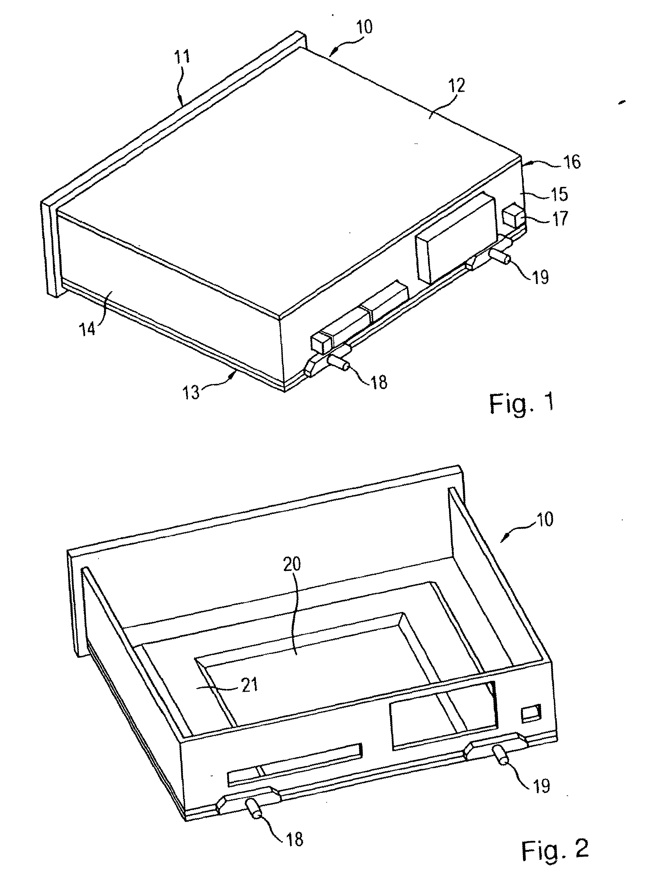

In Fig. 1, a perspective rear view of an electronic system incorporated into a vehicle is shown, the electronic system comprises a housing 10 having a front side 11 which is normally designed as an operating unit for controlling the functioning of the electronic system. The electronic system can be mounted in any available space in the vehicle with none of the housing sides being visible to the passenger. The electronic system may also be installed in an accommodating structure or support structure (not shown) in a passenger compartment of a vehicle. The front side 11 is visible to the passengers in the passenger compartment whereas the other sides are normally not visible and are contained in the space behind the dashboard. The housing comprises a top side 12, a lower or bottom side 13 and the three side surfaces 14, 15 and 16. On the side surface 15, being the back surface, connectors 17 may be provided which help to connect the electronic system to other components in the vehicle.

Furthermore, a fluid inlet 19 and a fluid outlet 18 are provided that can be connected to cooling fluid supply channels for supplying cooling fluid to the housing. The cooling fluid may be a synthetic liquid or water with the necessary additives. Furthermore, a pump, a heat sink, a coolant fluid reservoir and connection tubes (all not shown) may be provided to provide a cooling fluid circuit. The connection of the cooling fluid inlet and the cooling fluid outlet to the cooling circuit may be realized by quick couplers allowing an easy connection and disconnection at the inlet and outlet 19 and 18.

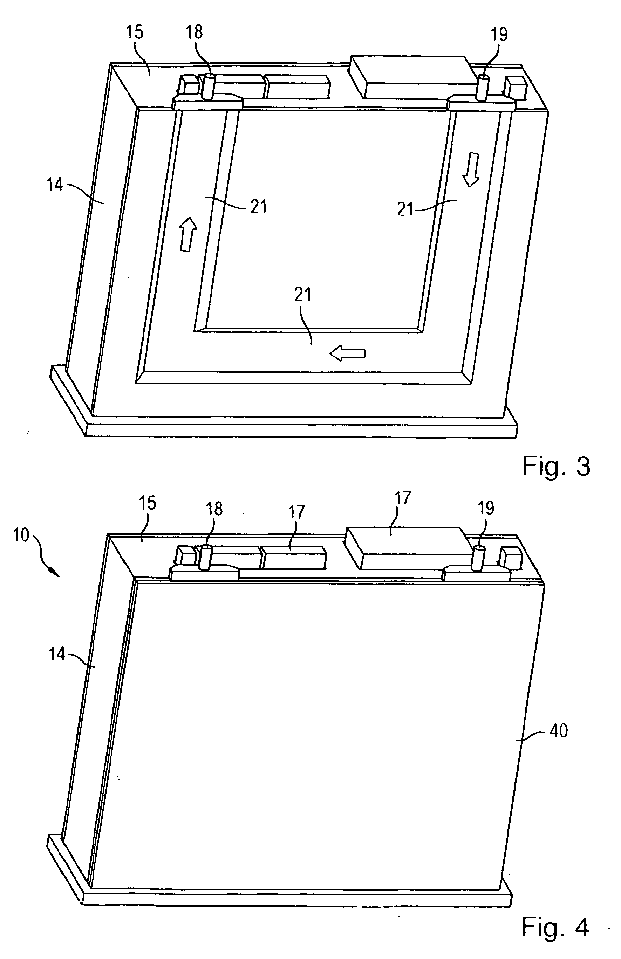

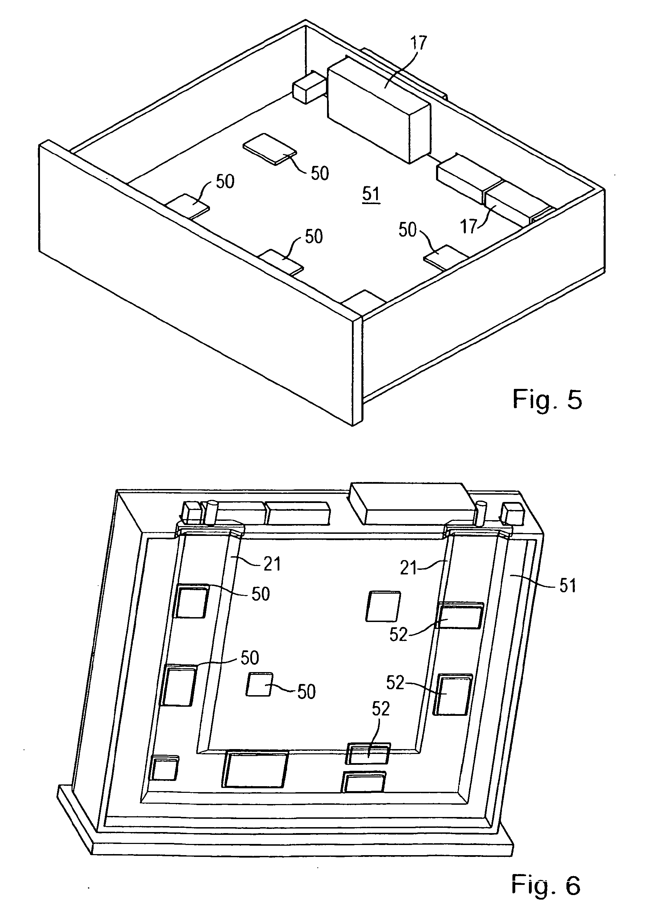

In Fig. 2, a perspective front view of the housing 10 is shown with the top side 12 and the front side 11 being removed. Next to the bottom of the housing, a heat sink plate 20 is provided, the heat sink plate extending substantially over the complete surface area of the housing. The heat sink plate is made of a good heat conducting material such as a metallic material. The heat sink plate 20 comprises a recessed area 21 having a U-shaped form, the recessed area 21 building a major part of the cooling fluid path through the housing. As will be explained in detail further below, the recessed area further builds the main contact area of heat sources 50 shown by way of example in Figs. 5 and 6. Accordingly, on one side of the heat sink plate, the heat sources are provided whereas on the other side, a cover plate 40 shown in Fig. 4 is provided. The cooling fluid channel is built by the recessed areas 21 of the heat sink plate and by the cover plate. In a sectional view, the cooling fluid channel is built on three sides by the recessed areas, the fourth side being built by the cover plate 40.

The recessed areas 21 start at the cooling fluid inlet 19, extend over the surface area of the housing building the cooling fluid channel and end at the fluid outlet 18. Depending on the number of heat sources to be cooled and/or depending on the space requirements within the housing a fluid path of varying length can be designed.

In Fig. 3, the cooling fluid channel built by the recessed areas 21 can be seen in more detail with the cover plate being removed. The path of the cooling fluid is schematically shown by the arrows shown in Fig. 3, the cooling fluid entering the housing at the cooling fluid inlet 19 follows the recessed areas 21 in the U-shaped form and exits the housing at the cooling fluid outlet 18.

In Fig. 4, the housing 10 is shown with the cover plate 14 being provided.

As can be seen from Figs. 1 to 4, the cooling system provided in the housing 10 needs only little space, but allows an effective cooling of the heat sources. The limited space requirements are obtained by using the cover plate 40 and the heat sink plate 20 attached to each other, the recessed areas in the heat sink plate providing the space for the cooling fluid. A cooling fluid can much better transfer the generated heat by direct convection. A chassis made from aluminum or an aluminum heat spreader for more effectively spreading the generated heat is not necessary anymore as the generated heat can be effectively removed using the cooling fluid path.

In Figs. 5 and 6, a main board 51 can be seen on which several heat sources 50 are provided. The heat sources 50 may be provided on the upper surface of the main board 51, but on the lower surface of the main board 51 facing the heat sink plate 20 additional heat sources are provided which are directly connected to the heat sink plate. As can be seen from Fig. 6, the heat sources are preferably placed at a position of the main board where the recessed areas 21 of the heat dissipating plate are provided, the recessed areas 21 being shown in phantom lines in Fig. 6. Heat sources generating a large amount of heat may be directly provided at positions at which the recessed areas are provided whereas other heat sources generating less heat may be provided at other positions on the main board. Between the heat sink plate (not shown) and the main board 51, heat conducting pads 52 may be provided, the heat conducting pads improving the heat transfer from the heat sources to the heat dissipating plate. As can be seen in Fig. 6, several heat sources can be cooled in series using a single cooling fluid path or circuit within the housing.

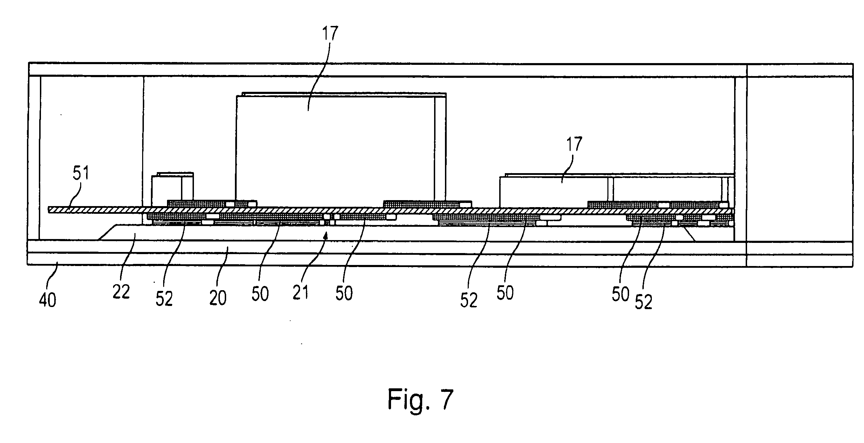

In Fig. 7, a partial sectional view is shown showing the sandwich structure of the housing and of the cooling fluid system. On the lower side, the cover plate 40 is provided, the cover plate building the bottom surface of the housing. Above the cover plate, the heat sink plate 20 with the recessed areas 21 is provided building the cooling fluid path 22. On the recessed areas 21, the heat sources 50 are provided, the heat conduction pads 52 being sandwiched between the recessed areas of the heat sink plate and the heat sources over the main board 51. As can be seen in Fig. 7, heat sources can be provided on both sides of the main board.

It should be understood that the bottom cover may be similarly shaped as the heat sink plate in order to increase the cooling surface area. In such an embodiment, it may also be possible to provide the heat sink structure not at an end surface of the housing but in the middle and to provide another circuit board on the other side of the cover plate, the other circuit board comprising additional heat sources connected to the cover plate that is also cooled by the cooling fluid.

Summarizing, the above-described cooling fluid system provides an effective cooling of heat sources at limited space requirements. The heat sources connected to the cooling system can operate at lower operating temperatures so that it may be possible to implement components specified for consumer electronics leading to a larger choice in selection of components and resulting in lower costs. Furthermore, the restrictions in the functionality imposed by the temperature management will be removed.

## Claims

1. Vehicle electronic system comprising:
- a housing (10) in which at least one heat source is provided,
- a cooling fluid channel (22) for guiding a cooling fluid through the housing,
- a heat sink plate (20) to which said at least one heat source (50) is connected, wherein the heat sink plate (20) comprises recessed areas (21) partly building the cooling fluid channel (22), **characterized in that** the vehicle electronic system is incorporated into a dashboard or main console of a vehicle cabin, wherein the side surfaces of the housing not facing the vehicle cabin are substantially free of air supply openings, wherein said at least one heat source (50) is connected to the heat sink plate (20) on the recessed areas (21).

2. The vehicle electronic system according to claim 1, further comprising a cover plate (40) building the cooling channel (22) together with the heat sink plate (20).

3. The vehicle electronic system according to claim 2, wherein the recessed areas (21) of the heat sink plate (20) build three side walls of the cooling fluid channel (22), the cover plate building the other side wall of the cooling fluid channel (22).

4. The vehicle electronic system according to any of the preceding claims, wherein a cooling fluid inlet (19) and a cooling fluid outlet (18) are provided on one side surface (15) of the housing.

5. The vehicle electronic system according to any of the preceding claims, wherein the cover plate (40) builds the bottom surface of the housing (10).

6. The vehicle electronic system according to any of the preceding claims, wherein said at least one heat source (50) is connected to the heat sink plate via a heat conducting pad (52).

7. The vehicle electronic system according to any of the preceding claims, wherein the cover plate (40) and the heat sink plate (20) are metallic plates and are connected to each other by brazing.

8. The vehicle electronic system according to any of the preceding claims wherein the heat sink plate (20) comprising the recessed areas (21) is a substantially planar surface extending substantially over the complete surface area of the housing (10).

9. The vehicle electronic system according to any of the preceding claims wherein the cover plate (40) is a substantially planar surface extending substantially over the complete surface area of the housing.

## Patentansprüche

1. Elektronisches Fahrzeugsystem umfassend:
- ein Gehäuse (10), in welchem mindestens eine Wärmequelle (50) versehen ist,
- ein Flüssigkeitskühlungskanal (22), um eine Kühlflüssigkeit durch das Gehäuse zu führen,
- eine Kühlkörperplatte (20) an welcher mindestens eine der Wärmequellen (50) befestigt ist, wobei die Kühlkörperplatte (20) vertiefte Bereiche (21) umfasst, welche teilweise den Flüssigkeitskühlungskanal bilden, **dadurch gekennzeichnet, dass** das elektronische Fahrzeugsystem in ein Armaturenbrett oder Hauptkonsole eine Fahrzeugkabine integriert ist, wobei die Seitenflächen des Gehäuses, welche nicht in Richtung der Fahrzeugkabine gerichtet sind, im Wesentlichen frei von Luftzufuhröffnungen sind, wobei mindestens eine der Wärmequellen (50) mit der Kühlkörperplatte an den vertieften Bereiche (21) verbunden ist.

2. Elektronisches Fahrzeugsystem nach Anspruch 1 weiter umfassend eine Abdeckplatte (40), welche zusammen mit der Kühlkörperplatte (20) den Flüssigkeitskühlungskanal (22) bildet.

3. Elektronisches Fahrzeugsystem nach Anspruch 2, wobei die vertieften Bereiche (21) der Kühlkörperplatte (20) drei Seitenwände des Flüssigkeitskühlungskanals (22) bilden, wobei die Abdeckplatte (40) die andere Seitenwand des Flüssigkeitskühlungskanals (22) bildet.

4. Elektronisches Fahrzeugsystem nach einen der vorhergehenden Ansprüche, wobei ein Kühlungsflüssigkeitseinlass (19) und ein Kühlungsflüssigkeitsauslass (18) an einer Seitenfläche (15) des Gehäuses vorgesehen sind.

5. Elektronisches Fahrzeugsystem nach einen der vorhergehenden Ansprüche, wobei die Abdeckplatte (40) die Unterseite des Gehäuses (10) bildet.

6. Elektronisches Fahrzeugsystem nach einen der vorhergehenden Ansprüche, wobei mindestens eine der Wärmequellen (50) mit der Kühlkörperplatte (20) mittels eines Wärmeleitkissens (52) verbunden ist.

7. Elektronisches Fahrzeugsystem nach einen der vorhergehenden Ansprüche, wobei die Abdeckplatte (40) and die Kühlkörperplatte (20) metallische Platten sind und beide gelötet miteinander verbunden sind.

8. Elektronisches Fahrzeugsystem nach einen der vorhergehenden Ansprüche, wobei die Kühlkörperplatte (20) mit den vertieften Bereichen (21) eine im Wesentlichen ebene Oberfläche im Wesentlichen über den gesamten Oberflächenbereich des Gehäuses (10) erstreckt.

9. Elektronisches Fahrzeugsystem nach einen der vorhergehenden Ansprüche, wobei die Abdeckplatte (40) eine im Wesentlichen ebene Oberfläche ist, die sich im Wesentlichen über den gesamten Oberflächenbereich des Gehäuses (10) erstreckt.

## Revendications

1. Système électronique de véhicule, comprenant:
- un boîtier (10) dans lequel est agencée au moins une source de chaleur,
- un canal de liquide de refroidissement (22) pour guider un liquide de refroidissement à travers le boîtier,
- une plaque de puits thermique (20) à laquelle est raccordée ladite au moins une source de chaleur (50),
dans lequel la plaque de puits thermique (20) comprend des zones renfoncées (21) constituant partiellement le canal de liquide de refroidissement (22), **caractérisé en ce que** le système électronique de véhicule est incorporé dans un tableau de bord ou une console principale d'un habitacle de véhicule, dans lequel les faces latérales du boîtier n'étant pas en regard de l'habitacle sont essentiellement dépourvues d'orifices d'alimentation en air, dans lequel ladite au moins une source de chaleur (50) est raccordée à la plaque de puits thermique (20) sur les zones renfoncées (21).

2. Système électronique de véhicule selon la revendication 1, comprenant en outre une plaque de recouvrement (40) constituant le canal de refroidissement (22) conjointement avec la plaque de puits thermique (20).

3. Système électronique de véhicule selon la revendication 2, dans lequel les zones renfoncées (21) de la plaque de puits thermique (20) constituent trois parois latérales du canal de liquide de refroidissement (22), la plaque de recouvrement constituant l'autre paroi latérale du canal de liquide de refroidissement (22).

4. Système électronique de véhicule selon l'une quelconque des revendications précédentes, dans lequel une entrée de liquide de refroidissement (19) et une sortie de liquide de refroidissement (18) sont agencées sur une face latérale (15) du boîtier.

5. Système électronique de véhicule selon l'une quelconque des revendications précédentes, dans lequel la plaque de recouvrement (40) constitue le fond du boîtier (10).

6. Système électronique de véhicule selon l'une quelconque des revendications précédentes, dans lequel ladite au moins une source de chaleur (50) est raccordée à la plaque de puits thermique par l'intermédiaire d'un tampon conducteur de chaleur (52).

7. Système électronique de véhicule selon l'une quelconque des revendications précédentes, dans lequel la plaque de recouvrement (40) et la plaque de puits thermique (20) sont des plaques métalliques et sont reliées l'une à l'autre par brasage.

8. Système électronique de véhicule selon l'une quelconque des revendications précédentes, dans lequel la plaque de puits thermique (20) comprenant les zones renfoncées (21) est une surface essentiellement plane s'étendant essentiellement à travers la surface complète du boîtier (10).

9. Système électronique de véhicule selon l'une quelconque des revendications précédentes, dans lequel la plaque de recouvrement (40) est une surface essentiellement plane s'étendant essentiellement à travers la surface complète du boîtier.
